# EUROPEAN PATENT APPLICATION

(11) **EP 3 136 454 A1**
(43) Date of publication of application: **01.03.2017**
(21) Application number: 15783497.9
(22) Date of filing: 02.04.2015
(51) Int. Cl.: H01L 33/50, C04B 35/00, C04B 35/50, C04B 41/87

(54) **WAVELENGTH CONVERSION JOINING MEMBER, WAVELENGTH CONVERSION HEAT-RADIATING MEMBER, AND LIGHT EMISSION DEVICE**

(30) Priority: 23.04.2014 JP 2014089568; 27.02.2015 JP 2015039031
(71) Applicant: Nitto Denko Corporation, Ibaraki-shi, Osaka 567-8680 (JP)
(72) Inventor: FUJII, Hironaka, Ibaraki-shi Osaka 567-8680 (JP); SHIRAKAWA, Masahiro, Ibaraki-shi Osaka 567-8680 (JP)
(74) Representative: Hoffmann Eitle
(86) International application number: PCT/JP2015/060516
(87) International publication number: WO 2015/163108

(57) **Abstract**

A wavelength conversion bonding member includes a phosphor ceramic element and a bonding layer provided on one side of the phosphor ceramic element, wherein the bonding layer has a thermal conductivity of more than 0.20 W/m·K, and the bonding layer has a reflectivity of 90% or more.

## Description

### TECHNICAL FIELD

The present invention relates to a wavelength conversion bonding member, a wavelength conversion heat dissipation member, and a light-emitting device; in particular, the present invention relates to a wavelength conversion bonding member, a wavelength conversion heat dissipation member including the wavelength conversion bonding member, and a light-emitting device including the wavelength conversion heat dissipation member.

### BACKGROUND ART

Recently, a light-emitting device such as semiconductor light-emitting devices are used for, for example, a lighting product for vehicles such as a headlight. Such a semiconductor light-emitting device includes an optical semiconductor that emits excitation light, a wavelength conversion member that converts the excitation light to white light, and a reflection mirror that reflects the white light in an aimed direction.

Patent Document 1 has proposed, for such a light-emitting device, for example, a light-emitting device below. That is, Patent Document 1 has proposed a light-emitting device including a pumping source that emits excitation light forward; a light-emitting portion that is disposed to face the front side of the pumping source in spaced-apart relation, and converts the excitation light to white light; a light-transmitting heat-conductive member disposed between the pumping source and the light-emitting portion; a light-transmitting gap layer disposed between the light-emitting portion and the heat-conductive member to be contact with these; a cup-shaped reflection mirror disposed to surround the peripheral of the rear side of the light-emitting portion in spaced-apart relation, and reflects white light diffused and released from the wavelength conversion member forward.

In the light-emitting device, the gap layer includes an inorganic amorphous material, and therefore the heat generated at the light-emitting portion can be conducted efficiently through the gap layer to the heat-conductive member, thus achieving excellent heat-releasing characteristics.

### Citation List

### Patent Document

Patent Document 1 Japanese Patent Publication No. 5021089

### [SUMMARY OF THE INVENTION]

### PROBLEM TO BE SOLVED BY THE INVENTION

However, in the light-emitting device of above-described Patent Document 1, as shown in FIG. 1, the gap layer is present between the pumping source and the light-emitting member, and therefore the gap layer absorbs the light generated from the pumping source. As a result, there are disadvantages in that the light directly released from the light-emitting portion to the outside may be reduced, or the light amount (light output) released from the light-emitting portion and diffused reflected from the reflection mirror and released to the outside may be reduced.

An object of the present invention is to provide a wavelength conversion bonding member, a wavelength conversion heat dissipation member, and a light-emitting device with excellent heat-releasing characteristics and reflectivity.

### MEANS FOR SOLVING THE PROBLEM

A wavelength conversion bonding member of the present invention includes a phosphor ceramic element and a bonding layer provided on one side of the phosphor ceramic element, wherein the bonding layer has a thermal conductivity of more than 0.20 W/m·K, and the bonding layer has a reflectivity of 90% or more.

In the wavelength conversion bonding member of the present invention, it is preferable that the bonding layer is formed from a ceramic ink.

In the wavelength conversion bonding member of the present invention, it is preferable that the bonding layer is formed from a curable resin composition containing a curable resin, and at least one inorganic particle selected from inorganic oxide particles and metal particles.

In the wavelength conversion bonding member of the present invention, it is preferable that the bonding layer has a thickness of 80 µm or more and 1000 µm or less.

A wavelength conversion heat dissipation member of the present invention includes the above-described wavelength conversion bonding member and a heat diffusion retention member, wherein the heat diffusion retention member is bonded to the phosphor ceramic element through the bonding layer.

A light-emitting device of the present invention includes a light source that applies light to one side; a reflection mirror that is disposed on one side to face the light source in spaced-apart relation, and in which a through hole for allowing light to pass through is formed; and the above-described wavelength conversion heat dissipation member disposed on one side to face the reflection mirror in spaced-apart relation so that the light is applied to the phosphor ceramic element.

### EFFECT OF THE INVENTION

The wavelength conversion bonding member, wavelength conversion heat dissipation member, and light-emitting device of the present invention includes a phosphor ceramic element, and a bonding layer provided on one side of the phosphor ceramic element, and the bonding layer has a thermal conductivity of more than 0.20 W/m·K. Therefore, the heat generated in the phosphor ceramic element can be efficiently conducted through the bonding layer, and excellent heat-releasing characteristics can be achieved.

In the wavelength conversion bonding member, wavelength conversion heat dissipation member, and light-emitting device of the present invention, the bonding layer has a reflectivity of 90% or more. Therefore, absorption of the light diffused and released in the phosphor ceramic element is suppressed, and can be reflected at high efficiency. As a result, excellent light output can be achieved.

### BRIEF DESCRIPTION OF THE DRAWINGS

FIG. 1 shows a side sectional view of the light-emitting device of the present invention in an embodiment.
FIG. 2A to FIG. 2B show a wavelength conversion heat dissipation member of the light-emitting device shown in FIG. 1, FIG. 2A is a side sectional view and FIG. 2B is a rear view.
FIG. 3A to FIG. 3E are process diagrams showing a method for producing the wavelength conversion heat dissipation member of the present invention in an embodiment, FIG. 3A illustrating a step of preparing a green sheet, FIG. 3B illustrating a step of baking the green sheet,
FIG. 3C illustrating a step of providing a bonding layer on a phosphor ceramic layer, FIG. 3D illustrating a step of cutting the wavelength conversion bonding sheet, and FIG. 3E illustrating a step of providing the wavelength conversion bonding member on a heat diffusion retention member.
FIG. 4A to FIG. 4B show the wavelength conversion heat dissipation member of the present invention in another embodiment (bonding layer having a U-shape when viewed in cross section), FIG. 4A is a side sectional view and FIG. 4B is a rear view.

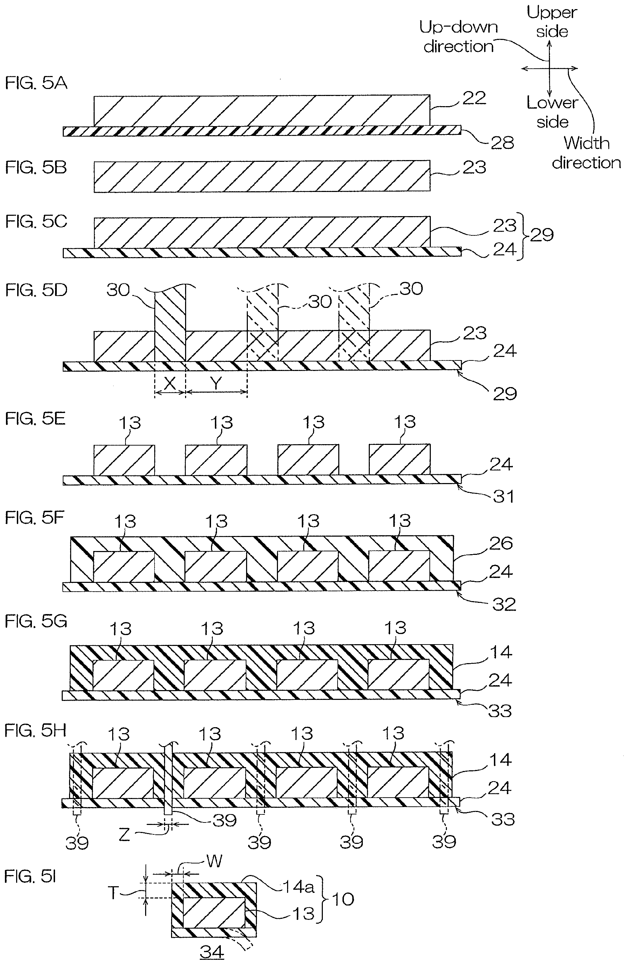

FIG. 5A to FIG. 5I show process diagram of a first production method for producing the wavelength conversion heat dissipation member of the present invention in another embodiment (bonding layer having a U-shape when viewed in cross section), FIG. 5A illustrating a step of preparing a green sheet, FIG. 5B illustrating a step of baking the green sheet, FIG. 5C illustrating a step of disposing the phosphor ceramic layer on a substrate, FIG. 5D illustrating a step of scraping off a portion of the phosphor ceramic layer, FIG. 5E illustrating a step of producing a phosphor ceramic element, FIG. 5F illustrating a step of forming a curable layer, FIG. 5G illustrating a step of forming a bonding layer, FIG. 5H illustrating a step of cutting the bonding layer and the substrate, and FIG. 5I illustrating a step of producing a wavelength conversion bonding member.
FIG. 6 shows a plan view in the step of FIG. 5E.

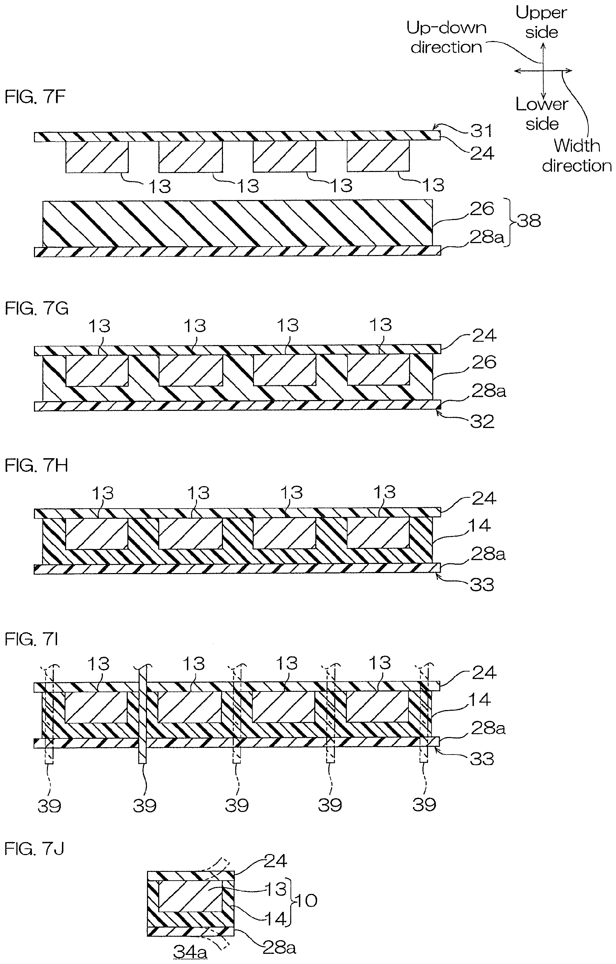

FIG. 7F to FIG. 7J show process diagram of a second production method for producing the wavelength conversion heat dissipation member of the present invention in another embodiment (bonding layer having a U-shape when viewed in cross section), FIG. 7F illustrating a step of disposing an element-disposed substrate to face the curable layer, FIG. 7G illustrating a step of embedding the phosphor ceramic element in the curable layer, FIG. 7H illustrating a step of curing the curable layer, FIG. 7I illustrating a step of cutting the bonding layer and the substrate, and FIG. 7J illustrating a step of producing a wavelength conversion bonding member.
FIG. 8 shows a side sectional view of the wavelength conversion heat dissipation member of the present invention in another embodiment (heat diffusion retention member having a comb shape when viewed in cross section).

### [DESCRIPTION OF EMBODIMENTS]

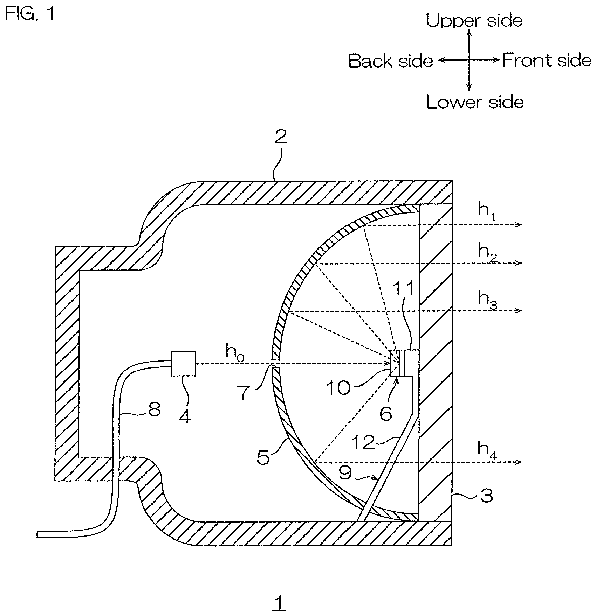

An embodiment of the light-emitting device of the present invention is described with reference to FIG. 1 to FIG. 2B.

The up-down direction on the plane of the sheet of FIG. 1 is referred to as "up-down direction" (first direction), the upper side on the plane of the sheet is upper side, and the lower side on the plane of the sheet is lower side. The left-right direction on the plane of the sheet of FIG. 1 is referred to as "front-back direction" (second direction, direction perpendicular to the first direction), the right direction on the plane of the sheet is front side, and the left direction on the plane of the sheet of FIG. 1 is back side. The paper thickness direction in FIG. 1 is referred to as "width direction" (third direction, left-right direction, direction perpendicular to first direction and second direction), the near side of the paper thickness direction of FIG. 1 is referred to as left side, and the far side of the paper thickness direction of FIG. 1 is right side. The directions in FIG. 1 are based on in other Figures as well.

As shown in FIG. 1, a semiconductor light-emitting device 1 as a light-emitting device includes a housing 2, a transparent member 3, a light source 4, a reflection mirror 5, and a wavelength conversion heat dissipation member 6.

The housing 2 is formed into a generally cylindrical shape so that it extends in front-back direction, and is closed at the back side and opened at the front side. The housing 2 accommodates the transparent member 3, the light source 4, the reflection mirror 5, and the wavelength conversion heat dissipation member 6 therein described later.

The transparent member 3 has a generally circular shape when viewed from the rear, and is formed into a flat plate shape having a thin thickness in front-back direction. The outline shape of the transparent member 3 is formed so as to coincide with the inner circumferential edge at the front edge of the housing 2 when projected in front-back direction.

The transparent member 3 is provided at the front edge of the housing 2. To be specific, the transparent member 3 is accommodated in the housing 2 so that the front end edge of the housing 2 is flush with the front face (front side surface) of the transparent member 3 in up-down direction.

Examples of the light source 4 include a semiconductor light source such as a light-emitting diode (LED) and a semiconductor laser (LD). The light source 4 is provided at a back side of the transparent member 3 in spaced-apart relation, at a generally center portion of the up-down direction and width direction inside the housing 2. To the light source 4, a wiring 8 drawn from the outside of the housing 2 is connected. The light source 4 applies light such as monochromatic light toward the front side by electric power received from the wiring 8.

The reflection mirror 5 has a generally circular shape when viewed from the rear, and is formed into a generally semi-arc dome shape when viewed in side cross section. The outline shape of the reflection mirror 5 is formed so as to coincide with the outer end edge of the transparent member 3 when projected in front-back direction. The reflection mirror 5 is disposed in spaced-apart relation with the light source 4 at the other side (back side) of the transparent member 3 and one side (front side) of the light source 4. The reflection mirror 5 is accommodated in the housing 2 so that its front end edge is in contact with the back face of the transparent member 3.

A through hole 7 for allowing the light from the light source 4 to pass through is formed at a center of the reflection mirror 5 (center in up-down direction and width direction). The reflection mirror 5 reflects the diffused light toward the front side: the light passes through the through hole 7 toward the front side and diffuses toward the back side at the wavelength conversion heat dissipation member 6 (described later).

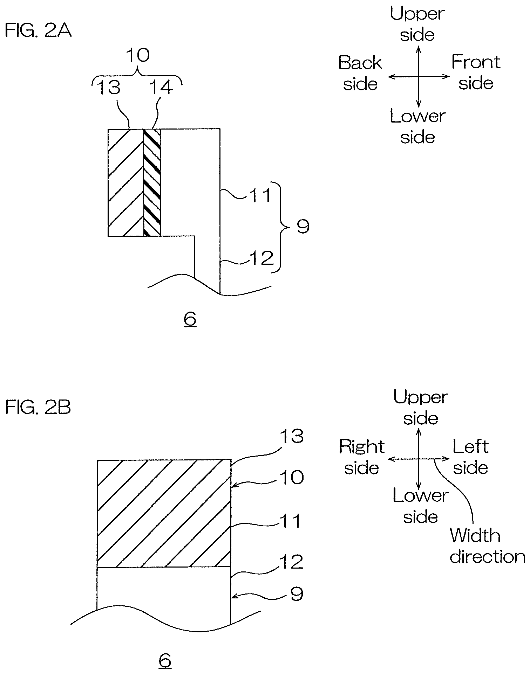

The wavelength conversion heat dissipation member 6 is provided at a front side in the housing 2. To be specific, the wavelength conversion heat dissipation member 6 is provided so as to face the reflection mirror 5 in spaced-apart relation at a front side, and is disposed adjacent to the back face (back side surface) of the transparent member 3. The wavelength conversion heat dissipation member 6 includes a heat diffusion retention member 9 and a wavelength conversion bonding member 10, as shown in FIG. 2A and FIG. 2B.

The heat diffusion retention member 9 is formed into a generally rectangular shape extending in up-down direction when viewed from the rear, and is disposed adjacent to the transparent member 3. To be specific, the heat diffusion retention member 9 is disposed so that the front face of the heat diffusion retention member 9 is in contact with the back face of the transparent member 3.

The heat diffusion retention member 9 includes a placement portion 11 and a fixing portion 12.

The placement portion 11 is formed into a generally rectangular shape when viewed from the rear having a thickness in front-back direction. The placement portion 11 is disposed so that the front face of the placement portion 11 is in contact with a generally center portion of the back face of the transparent member 3 when viewed from the rear.

The fixing portion 12 is formed integrally with the placement portion 11 so as to extend from the front side lower end of the placement portion 11 to the lower side. The fixing portion 12 is formed into a generally rectangular shape extending in up-down direction when viewed from the rear, and is formed into a flat plate shape having a thickness smaller than the thickness of the front-back direction of the placement portion 11. The upper side front face of the fixing portion 12 is in contact with the back face of the transparent member 3, and the fixing portion 12 is bent back side at a point in up-down direction so as to be spaced apart from the transparent member 3. One end (lower end) of the fixing portion 12 is fixed at the circumferential surface (inner end edge) of the housing 2, passing through the reflection mirror 5.

The heat diffusion retention member 9 is formed from a material having excellent thermal conductivity, for example, from thermal conductive metal such as aluminum and copper, and ceramic materials such as A1N.

The wavelength conversion bonding member 10 is provided at a back face of the placement portion 11.

The wavelength conversion bonding member 10 includes a bonding layer 14 and a phosphor ceramic element 13.

The bonding layer 14 has a generally rectangular shape when viewed from the rear, and is formed into a flat plate shape. The bonding layer 14 is provided at the back face of a placement portion 11 and the front face (one side) of the phosphor ceramic element 13. That is, the bonding layer 14 is disposed between the placement portion 11 and the phosphor ceramic element 13. The bonding layer 14 is overlapped with the placement portion 11 when projected in front-back direction. The bonding layer 14 is, to be specific, formed to have the same shape with the placement portion 11 when viewed from the rear.

The bonding layer 14 is formed from a composition containing inorganic substance, and preferably is formed by curing the curable composition containing the inorganic substance.

Examples of the curable composition include a ceramic ink, a curable resin composition containing a curable resin and inorganic particles, and an aqueous silicate solution containing alkali metal silicate and inorganic particles.

The ceramic ink contains, for example, inorganic ceramics, a binder such as organopolysiloxane, and a solvent, and is cured (solidified) at a low temperature (e.g., 120 to 180°C). Examples of the inorganic substance in the ceramic ink include white pigments such as silicon dioxide, titanium dioxide, and potassium titanate. Examples of the solvent include ethers such as butyldiglycolether and diethylene glycoldibutylether. In view of dispersiveness, white pigment is preferably subjected to surface treatment.

For the ceramic ink, a commercially available product can be used, and to be specific, examples thereof include ceramic inks manufactured by AIN Co., Ltd. (TYPE RG, TYPE AN, TYPE UV, and TYPE SD).

Examples of the curable resin contained in the curable resin composition include a curable silicone resin, an epoxy resin, and an acrylic resin. Preferably, a curable silicone resin is used.

Examples of the curable silicone resin include a condensation reaction curable silicone resin and an addition reaction curable silicone resin. Preferably, an addition reaction curable silicone resin is used.

The addition reaction curable silicone resin is composed of a silicone resin composition containing, for example, an ethylene-based unsaturated hydrocarbon group-containing polysiloxane as a main component, and organo hydrogen siloxane as a cross-linking agent. The addition reaction curable silicone resin is generally provided as two components of liquid A containing a main component (ethylene-based unsaturated hydrocarbon group-containing polysiloxane), and liquid B containing a cross-linking agent (organo hydrogen siloxane). Then, the main component (liquid A) and the cross-linking agent (liquid B) are mixed and a mixture is prepared, and in a step of forming the bonding layer 14 from the mixture, the ethylene-based unsaturated hydrocarbon group-containing polysiloxane and the organo hydrogen siloxane undergo addition reaction by heat, curing the addition reaction curable silicone resin to form silicone elastomer (cured product).

For the addition reaction curable silicone resin, a commercially available product (trade name: KER-2500, manufactured by Shin-Etsu Chemical Co., Ltd., trade name: LR-7665, manufactured by Wacker asahi kasei silicone co.,ltd., etc.) may be used.

Examples of the inorganic substance composing the inorganic particles include inorganic oxides such as silicon dioxide, titanium dioxide, aluminum oxide, zirconium oxide, and titanic acid composite oxide (e.g., barium titanate, potassium titanate), and metals such as silver and aluminum. In view of light reflectivity and heat-releasing characteristics, preferably, titanium dioxide, aluminum oxide, zirconium oxide, barium titanate, and silver are used, and in view of long-term heat resistance, more preferably, titanium dioxide, aluminum oxide, zirconium oxide, and barium titanate are used, even more preferably, titanium dioxide, and aluminum oxide are used.

The inorganic particles have an average particle size (average maximum length) of, for example, 0.1 to 50 µm.

For the curable resin composition, preferably used is a curable resin composition containing a curable silicone resin and inorganic particles composed of at least one selected from the group consisting of titanium dioxide, aluminum oxide, zirconium oxide, barium titanate, and silver; more preferably used is a curable resin composition containing a curable silicone resin and inorganic particles composed of at least one selected from the group consisting of titanium dioxide, aluminum oxide, zirconium oxide, and barium titanate; even more preferably used is a curable resin composition containing a curable silicone resin and inorganic particles composed of at least one of titanium dioxide and aluminum oxide.

Examples of the alkali metalsilicate included in the aqueous silicate solution include sodium silicate (water glass).

The curable composition has an inorganic substance content (solid content) of, for example, 30 mass% or more, preferably 40 mass% or more, more preferably 60 mass% or more, and for example, 90 mass% or less, preferably 80 mass% or less. The curable composition has a binder or curable resin content (solid content) of, for example, 10 mass% or more, preferably 20 mass% or more, and for example, 70 mass% or less, preferably 60 mass% or less, more preferably 40 mass% or less.

For the curable composition, preferably used are a ceramic ink and a curable resin composition containing a curable resin and at least one inorganic particle of inorganic oxide particles and metal particles; more preferably used are a ceramic ink and a curable resin composition containing a curable resin and inorganic oxide particles; even more preferably used is a ceramic ink. In this manner, heat-releasing characteristics and reflectivity of the bonding layer 14 can be improved.

The bonding layer 14 has a function as a heat dissipation layer, by which the heat generated at the phosphor ceramic element 13 is efficiently conducted to the heat diffusion retention member and as a reflection layer, by which the light entered and diffused in the phosphor ceramic element 13 is efficiently reflected to the back side.

The bonding layer 14 has a thermal conductivity of more than 0.20 W/m·K, preferably 1.0 W/m·K or more, more preferably 3.0 W/m·K or more, and for example, 30.0 W/m·K or less.

The thermal conductivity can be measured by an Xe flash analyzer.

The bonding layer 14 has a reflectivity of 90% or more, preferably 93% or more, more preferably 96% or more, and for example, 100% or less.

The reflectivity can be determined by measuring the reflection of light with a wavelength of 450 nm using an ultraviolet-visible spectrophotometer ("V 670", manufactured by JASCO Corporation).

The phosphor ceramic element 13 has a generally rectangular shape when viewed from the rear, and is formed into a flat plate shape. The phosphor ceramic element 13 is provided at the back face of the bonding layer 14. The phosphor ceramic element 13 is overlapped with the bonding layer 14 and the placement portion 11 when projected in front-back direction, to be specific, the phosphor ceramic element 13 is formed so as to have the same shape as those of the bonding layer 14 and the placement portion 11 when viewed from the rear.

The phosphor ceramic element 13 is disposed so that it is on the same line with the light source 4 and the through hole 7. To be specific, the light source 4, through hole 7, and phosphor ceramic element 13 are accommodated in the housing 2 so as to coincide with the axis line of the housing 2.

The phosphor ceramic element 13 is formed from ceramics (baked product) of the phosphor material. The phosphor contained in the phosphor ceramic element 13 has a wavelength conversion function, and examples thereof include yellow phosphor which can convert blue light to yellow light, and red phosphor which can convert blue light to red light.

Examples of yellow phosphor include silicate phosphors such as (Ba,Sr,Ca)₂SiO₄;Eu, and (Sr,Ba)₂SiO₄: Eu (barium orthosilicate (BOS)); garnet phosphor having a garnet crystal structure such as Y₃Al₅O₁₂: Ce (YAG (yttrium·aluminum·garnet): Ce) and Tb₃Al₃O₁₂: Ce (TAG (terbium·aluminum·garnet): Ce); and oxynitride phosphor such as Ca-α-SiAlON. Examples of the red phosphor include nitride phosphor such as CaAlSiN₃: Eu and CaSiN₂: Eu.

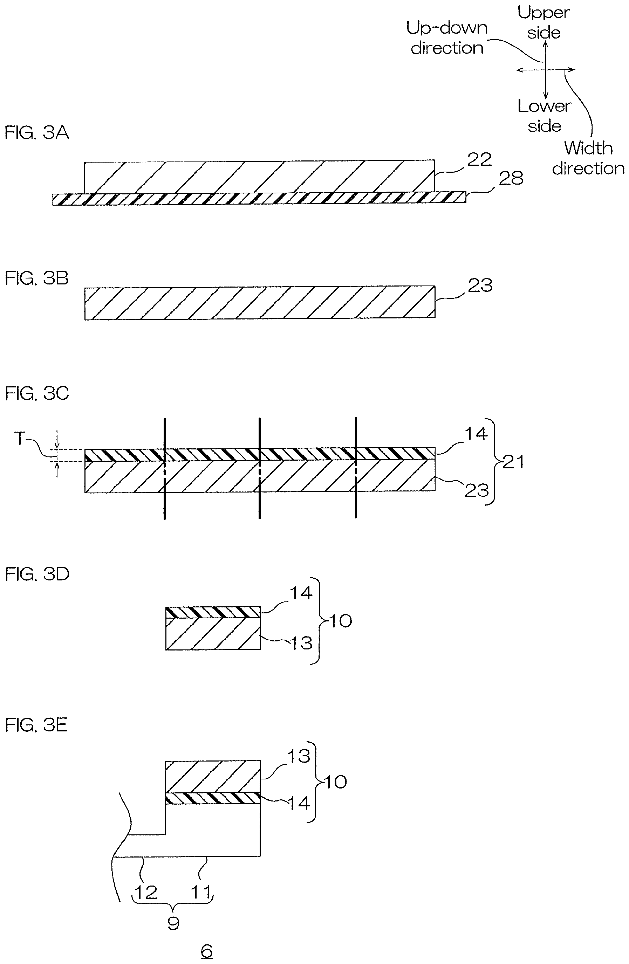

Next, a method for producing a wavelength conversion heat dissipation member 6 is described with reference to FIG. 3A to FIG. 3E.

The method for producing a wavelength conversion heat dissipation member 6 includes a step of preparing a green sheet 22, a step of baking the green sheet 22, a step of providing the bonding layer 14 on the phosphor ceramic layer 23, a step of cutting the wavelength conversion bonding sheet 21, and a step of providing the wavelength conversion bonding member 10 on the heat diffusion retention member 9.

First, as shown in FIG. 3A, the green sheet 22 is prepared (preparation step). The green sheet 22 is formed, for example, by applying and drying a slurry including a phosphor material, a binder resin, and a solvent on the surface of the release sheet 28.

The phosphor material is a raw material composing the above-described phosphor, and is prepared by suitably selecting from examples thereof including, for example, aluminum oxide, yttrium oxide, cerium oxide, zirconium oxide, titanium oxide, and furthermore, those materials added with other elements for activation.

For the binder resin, a known binder resin used for preparation of the green sheet 22 can be used, and examples thereof include acrylic polymer, butyral polymer, vinyl polymer, and urethane polymer. Preferably, acrylic polymer is used.

The binder resin content relative to a total volume amount of the phosphor material and binder resin is, for example, 5% by volume or more, preferably 20% by volume or more, and 80% by volume or less, preferably 60% by volume or less.

Examples of the solvent include water, and organic solvents such as acetone, methyl ethyl ketone, methanol, ethanol, toluene, methyl propionate, and methylcellsolve.

The solvent content in the slurry is, for example, 1 to 30 mass%.

For the slurry, as necessary, known additives such as a dispersing agent, a plasticizer, and a sintering auxiliary agent can be added.

Then, the above-described components are blended at the above-described ratio, and the mixture is subjected to wet blending with a ball mill, thereby preparing a slurry.

Then, the slurry is applied on the upper face of the release sheet 28 by known application methods such as doctor blade, gravure coater, fountain coater, cast coater, spin coater, and roll coater, and dried, thereby forming the green sheet 22.

Examples of the release sheet 28 include resin films such as polyester films including a polyethylene terephthalate (PET) film; a polycarbonate film; polyolefin films including a polyethylene film and a polypropylene film; a polystyrene film; an acrylic film; a silicone resin film; and a fluorine resin film. Furthermore, metal foils such as copper foil and stainless steel foil can be used. Preferably, a resin film, even more preferably, a polyester film is used.

The surface of the release sheet 28 is subjected to, as necessary, release treatment to improve release properties.

The release sheet 28 has a thickness of, for example, in view of handleability and costs, for example, 10 to 200 µm.

The thus produced green sheet 22 is a ceramics before sintering of the phosphor ceramic layer 23 (phosphor ceramic plate), and is formed into a generally rectangular flat plate shape when viewed from the top.

The green sheet 22 can also be formed by laminating a plurality of (a plurality of layers) green sheets 22 by heat lamination to obtain a desired thickness.

The green sheet 22 has a thickness of, for example, 10 µm or more, preferably 30 µm or more, and for example, 500 µm or less, preferably 200 µm or less.

Then, as shown in FIG. 3B, the green sheet 22 is baked (baking step). The phosphor ceramic layer 23(phosphor ceramic plate) is produced in this manner.

The baking temperature is, for example, 1300°C or more, preferably 1500°C or more, and for example, 2000°C or less, preferably 1800°C or less.

The baking time is, for example, 1 hour or more, preferably 2 hours or more, and for example, 24 hours or less, preferably 5 hours or less.

The baking can be performed under normal pressure, under reduced pressure, or under vacuum. Preferably, the baking can be performed under reduced pressure or vacuum.

Before the above-described baking (main baking), to thermally decompose and remove the organic component such as a binder resin and a dispersing agent, de-binder processing can be performed by using an electric furnace in air by preheating at, for example, 600 to 1300°C.

The speed of temperature increase in baking is, for example, 0.5 to 20°C/min.

The thus produced phosphor ceramic layer 23 is formed into a generally rectangular flat plate shape when viewed from the top.

The phosphor ceramic layer 23 has a thickness of, for example, 10 µm or more, preferably 50 µm or more, and for example, 500 µm or less, preferably 200 µm or less.

Then, as shown in FIG. 3C, the bonding layer 14 is provided on the phosphor ceramic layer 23 (bonding layer-forming step).

To be specific, the curable composition containing the inorganic substance is applied on the surface of the phosphor ceramic layer 23 by a known method, to form a curable layer on the surface of the phosphor ceramic layer 23. Then, the curable layer is cured (solidified) by, for example, heating, thereby forming the bonding layer 14.

The curable composition can be applied by known application methods such as doctor blade, gravure coater, fountain coater, cast coater, spin coater, and roll coater.

The heating temperature that causes curing of the curable layer is, for example, 100°C or more, preferably 120°C or more, and for example, 200°C or less, preferably 180°C or less.

The heating time is, for example, 0.5 hours or more, preferably 1 hour or more, and for example, 12 hours or less, preferably 6 hours or less.

As necessary, a drying step in which the curable layer is dried before thermosetting, for example, at 50 to 100°C for 1 to 10 hours.

In this manner, the bonding layer (bonding sheet) 14 is formed. That is, a wavelength conversion bonding sheet 21 including the phosphor ceramic layer 23, and the bonding layer 14 provided on the upper face of the phosphor ceramic layer 23 is produced.

The bonding layer 14 has a thickness T of, for example, 10 µm or more, preferably 50 µm or more, more preferably 80 µm or more, further preferably 90 µm or more, and for example, 1000 µm or less, preferably 500 µm or less, more preferably 200 µm or less, even more preferably 115 µm or less. Setting the thickness T in this range allows for the bonding layer 14 with more excellent thermal conductivity and reflectivity.

Then, as shown in dotted line of FIG. 3C, the wavelength conversion bonding sheet 21 is cut in up-down direction. To be specific, the wavelength conversion bonding sheet 21 is cut in up-down direction (thickness direction) to achieve a desired width direction length and a desired front-back direction length (in FIG. 3C, length in the paper thickness direction) (cutting step).

The cutting is performed by a known cutting device such as a dicing device, a scribing device, and a laser cutting device.

The phosphor ceramic layer 23 is cut into a desired size, producing a phosphor ceramic element 13 in this manner. That is, as shown in FIG. 3D, a wavelength conversion bonding member 10 including the phosphor ceramic element 13 and the bonding layer 14 provided on the upper face of the phosphor ceramic element 13 is produced.

The phosphor ceramic element 13 has a width direction length of, for example, 0.2 mm or more, preferably 1 mm or more, and for example, 10 mm or less, preferably 3 mm or less. The phosphor ceramic element 13 has a front-back direction length of, for example, 0.05 mm or more, preferably 0.1 mm or more, and for example, 5 mm or less, preferably 3 mm or less. The width direction length and the front-back direction length of the bonding layer 14 are the same as the width direction length and the front-back direction length of the phosphor ceramic element 13.

Then, as shown in FIG. 3E, a heat diffusion retention member 9 is provided in the wavelength conversion bonding member 10. To be specific, the bonding layer 14 of the wavelength conversion bonding member 10 is bonded to a placement portion 11 of the heat diffusion retention member 9 through the thermal conductive adhesive layer (not shown).

For the thermal conductive adhesive composing the thermal conductive adhesive layer, thermal conductive adhesive having a thermal conductivity will suffice, and the thermal conductivity is, for example, 1 to 20 W/m·k.

The thermal conductive adhesive layer has a thickness of, for example, 5 to 100 µm.

The wavelength conversion heat dissipation member 6 is produced in this manner.

Then, the upper side of the wavelength conversion heat dissipation member 6 shown in FIG. 3E is rotated so as to be the back side of FIG. 1, and the wavelength conversion heat dissipation member 6 is fixed to the housing 2 and to the transparent member 3, thereby producing the semiconductor light-emitting device 1 of FIG. 1.

Then, in the semiconductor light-emitting device 1 including the wavelength conversion heat dissipation member 6 of the present invention, the light h₀ applied from the light source 4 passes through the through hole 7, and at the same time with the wavelength of the light is converted to that of white light at the phosphor ceramic element 13, the light is diffused in omnidirection. At that time, the reflectivity of the bonding layer 14 disposed next to the phosphor ceramic element 13 is 90% or more, and therefore the diffused white light can be efficiently reflected to the reflection mirror 5 side (back side) (ref: h₁ to h₄ in FIG. 1). That is, while reducing loss of light amount at the wavelength conversion heat dissipation member 6, reflection to the reflection mirror 5 side can be achieved at high efficiency. Therefore, excellent light output released to the front side (and to the outside) at the reflection mirror 5 can be achieved.

Furthermore, the bonding layer 14 has a thermal conductivity of more than 0.20 W/m·K, and therefore the heat generated at the phosphor ceramic element 13, can be conducted efficiently through the bonding layer 14 to the heat diffusion retention member 9. Therefore, excellent heat-releasing characteristics can be achieved. Furthermore, the phosphor ceramic element 13 in which the wavelength of light is converted is formed from phosphor ceramics, and therefore excellent heat resistance and heat-releasing characteristics can be achieved.

The semiconductor light-emitting device 1 can be suitably used for, for example, far-reaching use such as lighting for vehicles, pendant lights, road lights, and stage lighting products.

### (Modified Example)

In the following Figures, for the members corresponding to the above-described members, the same reference numerals are given and detailed descriptions thereof are omitted.

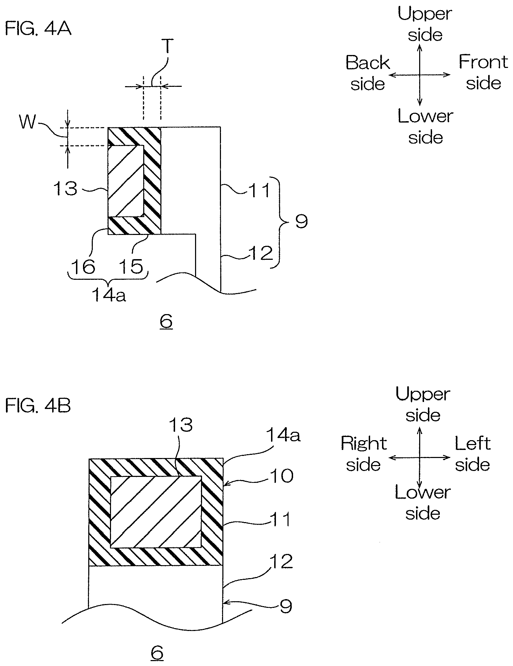

In the wavelength conversion heat dissipation member 6 of the embodiment shown in FIG. 2A, the bonding layer 14 is formed into a generally rectangular flat plate shape when viewed from the rear, but for example, as shown in FIG. 4A and FIG. 4B, the bonding layer 14 can be formed into a generally rectangular shape when viewed from the rear and a U-shape opening the back side when viewed in cross section.

The bonding layer 14a (U-shape in cross section) shown in FIG. 4A and FIG. 4B includes a base portion 15 formed into a generally rectangular flat plate shape when viewed from the rear, and a frame portion 16 projecting from the peripheral end of the base portion 15 to the back side.

The thickness T of the base portion 15 is the same as the thickness T of the bonding layer 14 shown in FIG. 3D.

The frame portion 16 has a width W of, for example, 10 µm or more, preferably 50 µm or more, and for example, 500 µm or less, preferably 200 µm or less.

The phosphor ceramic element 13 is formed to be the same as the inner edge of the frame portion 16, and is accommodated in the bonding layer 14a. That is, the back face of the phosphor ceramic element 13 is disposed to be flush with the rear end edge of the frame portion 16, and the front face of the phosphor ceramic element 13 is disposed to coincide with the back face of the base portion 15. In this manner, the front face of the phosphor ceramic element 13 is covered with the base portion 15, the peripheral side face of the phosphor ceramic element 13 is covered with the frame portion 16, and the back face of the phosphor ceramic element 13 is exposed from the bonding layer 14a.

In the embodiment of FIG. 4A and FIG. 4B, spreading of the white light applied to the phosphor ceramic element 13 and reflected and diffused can be suppressed. That is, the frame portion 16 is included, and therefore it prevents up-down diffusion of the white light reflected and diffused at the phosphor ceramic element 13. To be specific, light h₁ shown in FIG. 1 does not exit from the wavelength conversion heat dissipation member 6 of FIG. 4A, and the light in the range shown by the light h₂ to h₄ exits. Therefore, spreading of the light reflected to the front side can be limited, and light output to the front side direction in a specific range is improved.

Meanwhile, in the embodiment of FIG. 2A and FIG. 2B, spreading light in up-down direction (and width direction), for example, light h₁ to h₄ can be outputted.

A method of producing the embodiment of FIG. 4A and FIG. 4B is described with reference to FIG. 5A to FIG. 5I.

The method for producing a wavelength conversion heat dissipation member 6 shown in FIG. 4A and FIG. 4B includes a step of preparing a green sheet 22, a step of baking the green sheet 22, a step of disposing the phosphor ceramic layer 23 to the substrate 24, a step of scraping off a portion of the phosphor ceramic layer 23, a step of producing a phosphor ceramic element 13, a step of forming a curable layer 26, a step of curing the curable layer 26, a step of cutting the bonding layer 14 and the substrate 24, a step of producing the wavelength conversion bonding member 10, and a step of providing the wavelength conversion bonding member 10 on the heat diffusion retention member 9.

First, in the same manner as in FIG. 3A, as shown in FIG. 5A, a green sheet 22 is prepared (preparation step). Then, in the same manner as in FIG. 3B, as shown in FIG. 5B, the green sheet 22 is baked (baking step).

Then, as shown in FIG. 5C, the phosphor ceramic layer 23 is disposed on the substrate 24 (disposing step). To be specific, the phosphor ceramic layer 23 is disposed on a generally center portion of the upper face of the substrate 24.

For the substrate 24, in view of scraping off of the blade (described later), and removal of the substrate 24 relative to the wavelength conversion bonding member 10, preferably, an easy-release sheet is used. The easy-release sheet is formed, for example, by a thermal release sheet that can be released easily by heat.

The thermal release sheet includes a support layer, and a pressure-sensitive adhesive layer laminated on the upper face of the support layer.

The support layer is formed, for example, from a heat resistance resin such as polyester.

The pressure-sensitive adhesive layer has tackiness at, for example, normal temperature (25°C), and is formed from a thermal expansion adhesive whose tackiness decreases when heated (or loses adhesiveness).

For the thermal release sheet, a commercially available product can be used, and to be specific, REVALPHA series (registered trademark, manufactured by Nitto Denko Corporation) may be used.

The thermal release sheet is released from the wavelength conversion bonding member 10, based on reduction of tackiness of the pressure-sensitive adhesive layer by heat, while reliably supporting, by the support layer, the phosphor ceramic layer 23 (and the wavelength conversion bonding member 10) through the pressure-sensitive adhesive layer.

The substrate 24 can be formed from resin materials including vinyl polymers such as polyolefin (to be specific, polyethylene, polypropylene) and ethylene-vinyl acetate copolymer (EVA); polyesters such as polyethylene terephthalate and polycarbonate; and fluorine resin such as polytetrafluoroethylene. The substrate can be formed from, for example, metal materials such as iron, aluminum, and stainless steel.

The substrate 24 has a thickness of, for example, 10 to 1000 µm.

A ceramic laminate 29 including the substrate 24 and the phosphor ceramic layer 23 provided on the substrate 24 is produced in this manner.

Then, as shown in FIG. 5D, a portion of the phosphor ceramic layer 23 is removed (removal step). To be specific, a portion of the phosphor ceramic layer 23 is scraped off by using a blade such as dicing blade 30.

The dicing blade 30 is a disc rotary blade used for a known or commercially available dicing device. The distal end (lower end) of the dicing blade 30 is formed to be a generally rectangular shape (plate) extending in up-down direction (thickness direction of phosphor ceramic layer 23) when projected in the direction along the cutting direction (in FIG. 5D, front-back direction, i.e., paper thickness direction). That is, it is formed so that the cutting plane is a generally rectangular shape.

The dicing blade 30 has a width direction length X at the distal end of, for example, 0.05 mm or more, preferably 0.1 mm or more, and for example, 2.0 mm or less, preferably 1.0 mm or less.

In this step, first, as shown in FIG. 5D, a portion of the phosphor ceramic layer 23 is scraped off along the front-back direction.

To be specific, the ceramic laminate 29 is disposed in the dicing device so that the cutting direction is the front-back direction. Then, the positions of the dicing blade 30 or the ceramic laminate 29 are arranged so that when moving the dicing blade 30, the distal end (lower end) of the dicing blade 30 is in contact with the phosphor ceramic layer 23 and not penetrate the substrate 24. That is, the positions of the dicing blade 30 or the ceramic laminate 29 in up-down direction are adjusted so that the distal end of the dicing blade 30 reaches the upper face of the substrate 24, and does not reach the lower face of the substrate 24. Then, while rotating the dicing blade 30 at a high speed, the dicing blade 30 is moved in front-back direction along the cutting direction.

In this manner, the portion of the phosphor ceramic layer 23 contacting the dicing blade 30 (periphery of distal end) is scraped off from the substrate 24 along front-back direction. That is, the phosphor ceramic layer 23 is scraped off into a generally rectangular shape. At the portion scraped off, the upper face of the substrate 24 is exposed.

The scraping off in the front-back direction is repeatedly performed, as shown in the phantom line in FIG. 5D, with a desired interval (that is, desired width direction length of the phosphor ceramic element 13).

Then, in the same manner as described above, while rotating the dicing blade 30 at a high speed, the dicing blade 30 is moved so that the cutting direction is moved along the width direction, thereby scraping off a portion of the phosphor ceramic layer 23 in the width direction. The scraping off in the width direction is repeatedly performed with a desired interval.

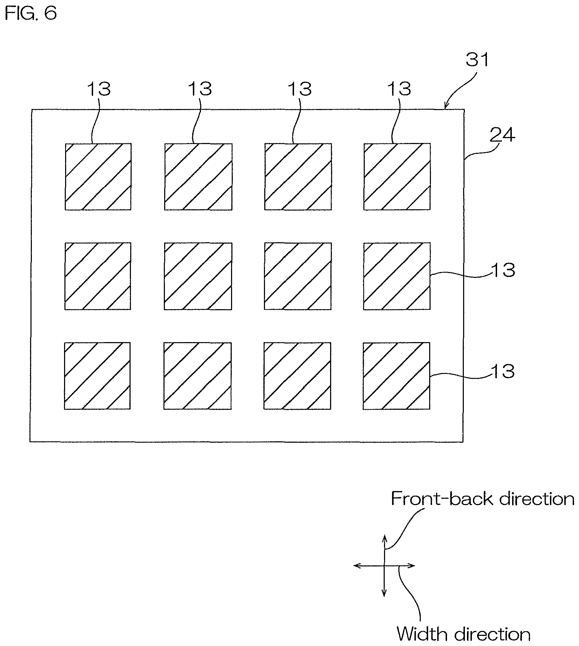

That is, as shown in FIG. 6, the phosphor ceramic layer 23 is scraped off like a grid.

In this manner, as shown in FIG. 5E and FIG. 6, an element-disposed substrate 31 including a substrate 24, and a plurality of phosphor ceramic elements 13 arranged in line like a grid on the upper face of the substrate 24 is produced.

In the above-described step, a portion of the phosphor ceramic layer 23 is scraped off by fixing the phosphor ceramic layer 23 and moving the dicing blade 30. However, for example, the position of the dicing blade 30 rotating at a high speed can be fixed, and by moving the ceramic laminate 29 relative to the dicing blade 30 with, for example, an X-Y stage, in front-back direction or width direction, a portion of the phosphor ceramic layer 23 can be scraped off.

The phosphor ceramic element 13 is formed into a generally rectangular shape when viewed in cross section and a generally rectangular shape when viewed from the top.

The width direction length Y and the front-back direction length of the phosphor ceramic element 13 are the same as in the embodiment of FIG. 2A and FIG. 2B.

The width direction interval and the front-back direction interval of the plurality of the phosphor ceramic element 13 are the same as the width direction length X of the distal end of the dicing blade 30.

Then, as shown in FIG. 5F and FIG. 5G, the bonding layer 14 is formed on the substrate 24 (forming step) so as to cover the surface of the phosphor ceramic element 13.

In the forming step, first, as shown in FIG. 5F, a curable composition containing the inorganic substance is applied on the substrate 24 by a known method so as to cover the upper face and the side face of the phosphor ceramic element 13, thereby forming the curable layer 26 (curable layer forming step).

For the application method of the curable composition, known application methods such as printing and dispensing can be used.

In this manner, a curable layer-element laminate 32 including a substrate 24, a plurality of phosphor ceramic elements 13 arranged in line on the substrate 24, and a curable layer 26 formed on the substrate 24 so as to cover the upper face and the side face of the plurality of phosphor ceramic elements 13 is produced.

Then, as shown in FIG. 5G, a bonding layer 14 is formed (bonding layer-forming step). To be specific, a bonding layer 14 is formed, in the same manner as in FIG. 3C, by curing (solidifying) the curable layer 26 by heating.

The bonding layer-element laminate 33 including the substrate 24, a plurality of phosphor ceramic elements 13 arranged in line on the substrate 24, and a bonding layer 14 formed on the substrate 24 so as to cover the upper face and side face of the plurality of phosphor ceramic elements 13 is produced in this manner.

Then, as shown in FIG. 5H, the bonding layer 14 and the substrate 24 are cut in up-down direction (cutting step) so as to include one phosphor ceramic element 13. That is, the phosphor ceramic elements 13 are separated into individual pieces (individualized) by cutting into the plurality of phosphor ceramic elements 13.

To be specific, the bonding layer 14 and the substrate 24 are cut using a narrow-width blade 39 by dicing between the phosphor ceramic elements 13 next to each other, along the up-down direction (thickness direction of the bonding layer-element laminate 33).

The narrow-width blade 39 is a blade having a narrower width than that of the dicing blade 30, and is a disc rotary blade used for dicing devices. The narrow-width blade 39 is formed into a generally rectangular shape (plate shape) extending in up-down direction when projected along the cutting direction (in FIG. 5H, front-back direction, i.e., paper thickness direction).

The narrow-width blade 39 has a width direction length Z that is smaller than the width direction length X of the dicing blade 30, and the width direction length Z is, for example, 80% or less, preferably 60% or less, and for example, 10% or more, preferably 30% or more of X. To be specific, for example, 0.01 mm or more, preferably 0.05 mm or more, and for example, 1.5 mm or less, preferably 0.8 mm or less.

In this cutting step, the bonding layer-element laminate 33 is disposed in the dicing device. Then, the positions of the narrow-width blade 39 or the bonding layer-element laminate 33 are adjusted so as to cut the bonding layer 14 and the substrate 24 in up-down direction. That is, the position of the narrow-width blade 39 or the bonding layer-element laminate 33 in up-down direction is adjusted so that the distal end of the narrow-width blade 39 penetrates the bonding layer 14 and reaches the lower face of the substrate 24. Then, in the same manner as in the above-described removal step, while rotating the narrow-width blade 39 at a high speed, the narrow-width blade 39 is moved in front-back direction and width direction (that is, like a grid) between the phosphor ceramic elements 13 next to each other, thereby cutting the bonding layer 14 and the substrate 24.

As shown in FIG. 5I, the wavelength conversion bonding member 10 is produced in this manner. To be specific, a substrate-laminate wavelength conversion bonding member 34 including the substrate 24, and the wavelength conversion bonding member 10 including the one phosphor ceramic element 13 and (U-shape in cross section) bonding layer 14a provided on the substrate 24 is produced in this manner.

Then, as shown in the phantom line of FIG. 5I, after removing the substrate 24, in the same manner as in the step of FIG. 3E, the wavelength conversion bonding member 10 is provided in the heat diffusion retention member 9.

The wavelength conversion heat dissipation member 6 shown in FIG. 4A and 4B is produced in this manner.

The wavelength conversion heat dissipation member 6 shown in FIG. 4A and 4B can also be produced by the method shown in FIG. 7F to FIG. 7J.

First, in the same manner as in FIG. 5A to FIG. 5E, an element-disposed substrate 31 including a substrate 24, and a plurality of phosphor ceramic elements 13 arranged in line like a grid on the upper face of the substrate 24 is produced.

Then, as shown in FIG. 7F, the element-disposed substrate 31 is disposed to face the curable layer 26 (disposing face to face step). To be specific, first, a curable layer sheet 38 having a curable layer 26 provided on a release sheet 28a is prepared. The curable layer sheet 38 is produced by applying the curable composition containing the inorganic substance on the upper face of the release sheet 28a on the release sheet 28a by a known method.

The release sheet 28a is the same as the release sheet 28.

The curable layer 26 has a thickness of, for example, 80 µm or more, preferably 90 µm or more, and for example, 1000 µm or less, preferably 500 µm or less.

Then, the element-disposed substrate 31 is disposed to face the curable layer sheet 38 in spaced-apart relation in up-down direction so that the phosphor ceramic element 13 faces the curable layer 26.

Then, as shown in FIG. 7G, the phosphor ceramic element 13 is embedded in the curable layer 26 (embedding step). To be specific, the element-disposed substrate 31 is moved to the lower side, and pressed against the curable layer sheet 38.

In this manner, the surface of the phosphor ceramic element 13 (lower face and side face) is covered with the curable layer 26. At the same time, the surface of the substrate 24 exposed from the phosphor ceramic element 13 is covered with the curable layer 26.

The pressure is, for example, 0.03MPa or more, preferably 0.1MPa or more, and for example, 2MPa or less, preferably 0.5MPa or less.

In this manner, a curable layer-element laminate 32 including the substrate 24, a plurality of phosphor ceramic elements 13 arranged in line below the substrate 24, the curable layer 26 formed below the substrate 24 so as to cover the lower face and side face of the plurality of phosphor ceramic elements 13, and the release sheet 28a disposed below the curable layer 26 is produced.

The step of disposing the element-disposed substrate 31 to face the curable layer sheet 38, and the step of embedding the phosphor ceramic element 13 in the curable layer 26 can be performed continuously as one step.

Then, as shown in FIG. 7H, the curable layer 26 can be cured (curing step). To be specific, in the same manner as in FIG. 3C, the curable layer-element laminate 32 is heated to cure (solidify) the curable layer 26, thereby forming a bonding layer 14.

The bonding layer-element laminate 33 including the substrate 24, the plurality of phosphor ceramic elements 13 arranged in line below the substrate 24, the bonding layer 14 formed below the substrate 24 so as to cover the lower face and the side face of the plurality of phosphor ceramic elements 13, and the release sheet 28a disposed below the bonding layer 14 is produced in this manner.

Then, as shown in FIG. 7I, the bonding layer 14 and the substrate 24 are cut in up-down direction so as to be include one phosphor ceramic element 13 (cutting step). That is, the phosphor ceramic elements 13 are separated into individual pieces (individualized) by cutting into a plurality of phosphor ceramic elements 13.

To be specific, in the same manner as in FIG. 5H, the substrate 24, the bonding layer 14, and the release sheet 28a are cut by dicing along up-down direction using a narrow-width blade 39 between the phosphor ceramic elements 13 next to each other.

As shown in FIG. 7J, the wavelength conversion bonding member 10 is produced in this manner. To be specific, a double-sided wavelength conversion bonding member 34a including the substrate 24, the release sheet 28a, and the wavelength conversion bonding member 10 sandwiched by these and including the phosphor ceramic element 13 and (U-shape in cross section) bonding layer 14a is produced in this manner.

Then, as shown in the phantom line of FIG. 7J, after releasing the substrate 24 and the release sheet 28a, in the same manner as in the step of FIG. 3E, the wavelength conversion bonding member 10 is provided on the heat diffusion retention member 9.

The wavelength conversion heat dissipation member 6 shown in FIG. 4A and 4B is produced in this manner.

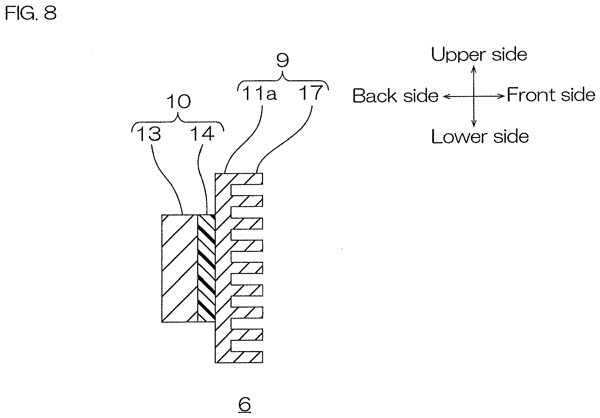

In the embodiment of FIG. 2A, the heat diffusion retention member 9 includes the placement portion 11 and the fixing portion 12, for example, as shown in FIG. 8, the heat diffusion retention member 9 can be formed into a comb shape when viewed in cross section, including a placement portion 11a and a plurality of projections 17.

The placement portion 11a is formed into a generally rectangular shape when viewed from the rear having a thickness in front-back direction, and is formed to be larger than the wavelength conversion bonding member 10. To be specific, the placement portion 11a is formed so as to include the wavelength conversion bonding member 10 when projected in front-back direction.

The plurality of projections 17 are formed integrally with the placement portion 11a, and provided so as to project from the front face of the placement portion 11a to the front side, to improve heat-releasing characteristics.

The embodiment of FIG. 8 also has the same operations and effects as those of the embodiment of FIG. 2A.

### [Examples]

In the following, the present invention is described in further detail with reference to Examples and Comparative Examples. However, the present invention is not limited to these. The specific numeral values such as mixing ratio (content), physical property values, and parameters used in the description below can be replaced with the upper limit value (numeral values defined with "or less", "less than") or the lower limit value (numeral values defined with "or more", "more than") of the corresponding mixing ratio (content), physical property values, parameters in the above-described "DESCRIPTION OF EMBODIMENTS".

### (Production of phosphor ceramic layer)

A phosphor material powder composed of 11.34 g of yttrium oxide particles (purity 99.9%, manufactured by Nippon yttrium co., ltd.), 8.577 g of aluminum oxide particles (purity 99.9%, manufactured by Sumitomo Chemical Co., Ltd.), and 0.087 g of cerium oxide particles was prepared.

20 g of phosphor material powder prepared was mixed with water soluble binder resin ("WB 4101 ", manufactured by Polymer Innovations, Inc.) so that the solid content volume ratio was 60: 40, and furthermore, distilled water was added. The mixture was put into an alumina-made vessel, zirconia balls having a diameter of 3 mm were added, and the mixture was subjected to wet blending with a ball mill for 24 hours, thereby preparing a slurry of phosphor material particles.

Then, the prepared slurry was tape-casted on a PET film 28 as a release sheet by doctor blade method and dried, thereby forming a green sheet 22 having a thickness of 75 µm (ref: FIG. 3A). Thereafter, the green sheet 22 was removed from the PET film 28, and the green sheet 22 was cut into a size of 20 mm × 20 mm. Two sheets of the green sheet 22 that was cut were prepared, and the two green sheets 22 were heat laminated using a hot press, thereby preparing the green sheet laminate 22.

Then, the prepared green sheet laminate 22 was heated in an electric muffle furnace in air at a temperature increase speed of 1°C/min to 1200°C, and de-binder processing was performed, in which an organic component such as binder resin is decomposed and removed. Thereafter, the green sheet laminate 22 was transferred to a high temperature vacuum furnace, and heated under reduced pressure of about 10⁻³Torr (about 0.13Pa) and a temperature increase speed of 5°C/min to 1750°C. The baking was performed at that temperature for 3 hours, thereby producing a phosphor ceramic layer 23(phosphor ceramic plate) having a thickness of 120 µm and composed of Y₃Al₅O₁₂: Ce (ref :FIG. 3B).

### (Preparation of curable composition for bonding layer production)

### Preparation Example 1

A ceramic ink (trade name "RG 12-22", white, rich in inorganic substance, manufactured by AIN Co., Ltd.) was prepared as a curable composition for bonding layer production.

### Preparation Example 2

Liquid A: Liquid B of a two-component addition reaction curable silicone resin (trade name "KER 2500-A/B", manufactured by Shin-Etsu Chemical Co., Ltd.) were mixed at a mixing ratio of 100: 100 (mass ratio), and then to 5.0 g of the mixture liquid, 2.0 g of silver particles (trade name "AG-404", manufactured by The Nilaco Corporation) and 3.0 g of silver particles (trade name "SPN 08S", manufactured by Mitsui Mining & Smelting Co., Ltd.) were mixed and stirred, thereby preparing a curable composition for bonding layer production.

### Preparation Example 3

Liquid A: liquid B of a two-component addition reaction curable silicone resin (trade name "KER 2500-A/B", manufactured by Shin-Etsu Chemical Co., Ltd.) was mixed at a mixing ratio of 100: 100 (mass ratio), and to 6.0 g of the mixture liquid, 4.0 g of barium titanate particles ("BT-03", manufactured by Sakai Chemical Industry Co., Ltd.) was mixed and stirred, thereby preparing a curable composition for bonding layer production.

### Preparation Example 4

To 6.0 g of sodium silicate (water glass) no. 1 (manufactured by Showa Chemical Industry Co., Ltd.), 4.0 g of barium titanate particles (trade name "BT-03", manufactured by Sakai Chemical Industry Co., Ltd.) were mixed and stirred, thereby preparing a curable composition for bonding layer production.

### Preparation Example 5

Liquid A: liquid B of a two-component addition reaction curable silicone resin (trade name "KER 2500-A/B", manufactured by Shin-Etsu Chemical Co., Ltd.) were mixed at a mixing ratio of 100: 100 (mass ratio), and then to 5.0 g of the mixture liquid, 5.5 g of rutile type titanium dioxide particles (average particle size 0.2 µm) were mixed and stirred, thereby preparing a curable composition for bonding layer production.

### Preparation Example 6

A curable composition (trade name "IVS 7620", manufactured by Momentive Performance Materials Inc.) containing 60 to 100 parts by mass of aluminum oxide particles and a curable silicone resin (10 to 30 parts by mass of silicone resin, 1 to 5 parts by mass of polyvinylsiloxane, 1 to 5 parts by mass of vinylpolydimethylsiloxane, and 1 to 5 parts by mass of methyl hydrogen polysiloxane) was prepared as a curable composition for bonding layer production.

### Preparation Example 7

A silver paste (trade name "P-1032", manufactured by MUROMACHI TECHNOS CO., LTD.) was prepared as a curable composition for bonding layer production.

### Preparation Example 8

5.0 g of methacryl resin pellets were dissolved in 15 g of methyl ethyl ketone, and 5.0 g of barium titanate particles (trade name"BT-03", manufactured by Sakai Chemical Industry Co., Ltd.) were mixed and stirred, thereby preparing a curable composition for bonding layer production.

### (Production of wavelength conversion bonding member)

### Example 1

The curable composition (ceramic ink) prepared in Preparation Example 1 was applied on one side of the phosphor ceramic layer 23 using a doctor blade, and heated at 90°C for 5 hours, thereby drying the ceramic ink, and then heated at 150°C for 2 hours, thereby curing the ceramic ink. In this manner, a wavelength conversion bonding sheet 21 including the phosphor ceramic layer 23 (thickness 120 µm) and the bonding layer 14 (thickness 100 µm) was produced (ref: FIG. 3C).

Then, the wavelength conversion bonding sheet 21 was cut into a size of 3.0 mm × 3.0 mm with a dicing device, thereby producing a wavelength conversion bonding member 10 including the phosphor ceramic element 13 and the bonding layer 14 (ref: FIG. 3D).

### Example 2

A wavelength conversion bonding member was made in the same manner as in Example 1, except that the thickness of the bonding layer was changed from 100 µm to 120 µm.

### Example 3

A wavelength conversion bonding member was made in the same manner as in Example 1, except that the curable composition of Preparation Example 1 was changed to the curable composition of Preparation Example 2, heating and drying were conducted at 70°C for 1 hour, and thermal curing was conducted at 150°C for 2 hours.

### Example 4

A wavelength conversion bonding member was made in the same manner as in Example 1, except that the curable composition of Preparation Example 1 was changed to the curable composition of Preparation Example 3, heating and drying were conducted at 70°C for 1 hour, and thermal curing was conducted at 150°C for 2 hours.

### Example 5

A wavelength conversion bonding member was made in the same manner as in Example 1, except that the curable composition of Preparation Example 1 was changed to the curable composition of Preparation Example 4, heating and drying were conducted at 70°C for 8 hours, and thermal curing was conducted at 150°C for 2 hours.

### Example 6

A wavelength conversion bonding member was made in the same manner as in Example 1, except that the curable composition of Preparation Example 1 was changed to the curable composition of Preparation Example 5, heating and drying were conducted at 70°C for 1 hour, and thermal curing was conducted at 150°C for 2 hours.

### Example 7

A wavelength conversion bonding member was made in the same manner as in Example 1, except that the curable composition of Preparation Example 1 was changed to the curable composition of Preparation Example 6, heating and drying were conducted at 100°C for 1 hour, and thermal curing was conducted at 150°C for 2 hours.

### Comparative Example 1

A wavelength conversion bonding member was made in the same manner as in Example 1, except that the thickness of the bonding layer was changed from 100 µm to 75 µm.

### Comparative Example 2

A wavelength conversion bonding member was made in the same manner as in Example 4, except that the thickness of the bonding layer was changed from 100 µm to 75 µm.

### Comparative Example 3

A wavelength conversion bonding member was made in the same manner as in Example 1, except that the curable composition of Preparation Example 1 was changed to the curable composition of Preparation Example 7, heating and drying were conducted at 70°C for 1 hour, and thermal curing was conducted at 150°C for 1 hour.

### Comparative Example 4

A wavelength conversion bonding member was made in the same manner as in Example 1, except that the curable composition of Preparation Example 1 was changed to the curable composition of Preparation Example 8, and heating and drying were conducted at 60°C for 2 hours.

### Example 8

The phosphor ceramic layer 23 was bonded to the pressure-sensitive adhesive layer side (upper face) of the thermal release sheet 24 (substrate, trade name "REVALPHA 31950", manufactured by Nitto Denko Corporation) set on the dicing frame of the dicing device (trade name "Dicing saw", Manufactured by DISCO Corporation), thereby producing a ceramic laminate 29 (ref: FIG. 5C).

Then, the position in up-down direction of the dicing blade 30 (distal end width X: 0.4 mm) having a distal end with a generally rectangular shape when viewed in cross section was adjusted so that the distal end of the dicing blade 30 coincided with the upper face of the thermal release sheet 24.

Then, while rotating the dicing blade 30 at a high speed, the dicing blade 30 was moved relative to the ceramic laminate 29 so that the width direction interval (Y) and front-back direction interval were 3.0 mm, thereby scraping off a portion of the phosphor ceramic layer 23 into a grid-like form (ref: FIG. 5D).

In this manner, an element-disposed substrate 31 was produced. In the element-disposed substrate 31, a plurality of phosphor ceramic elements 13 (3.0 mm × 3.0 mm) were arranged in line in spaced-apart relation with an interval of 0.4 mm in front-back direction and width direction like a grid on the thermal release sheet 24 (ref: FIG. 5E and FIG. 6).

Then, the curable composition of Preparation Example 1 as the material of the curable layer 26 was applied on the upper face and the side face of the phosphor ceramic element 13 with a doctor blade, thereby forming a curable layer 26. In this manner, a curable layer-element laminate 32 was produced (ref: FIG. 5F).

Then, the curable layer-element laminate 32 was dried at 90°C for 5 hours, and thereafter, thermal curing was conducted at 150°C for 2 hours, thereby forming a bonding layer 14 (thickness 100µm). In this manner, the bonding layer-element laminate 33 was produced (ref: FIG. 5G).

Then, the bonding layer-element laminate 33 was disposed in the dicing device. Thereafter, using a narrow-width blade 39 (distal end width Z: 0.2 mm) having a distal end with a generally rectangular shape when viewed in cross section, the center in the width direction and the center in the front-back direction between the phosphor ceramic elements 13 were cut so as to penetrate the bonding layer 14 and the thermal release sheet 24 in up-down direction (ref: FIG. 5H). That is, the bonding layer-element laminate 33 was cut to give a size of 3.2 mm × 3.2 mm. The phosphor ceramic elements 13 were separated into individual pieces, and a substrate laminate wavelength conversion bonding member 34 was produced in this manner.

Then, the thermal release sheet 24 was removed at 200°C from the substrate laminate wavelength conversion bonding member 34. In this manner, a wavelength conversion bonding member 10 having one phosphor ceramic element 13 (3.0 mm × 3.0 mm, thickness 120 µm) and bonding layer 14 (3.2 mm × 3.2 mm, side face width W: 0.1 mm, thickness T: 100 µm) was made (ref: FIG. 5I).

### (Bonding layer reflectivity: initial reflectivity)

The reflectivity at the bonding layer 14 of the wavelength conversion bonding member 10 of Examples and Comparative Examples was measured with a condition of a wavelength of 450 nm using an ultraviolet-visible spectrophotometer ("V 670", manufactured by JASCO Corporation). The results are shown in Table 1.

### (Thermal conductivity of bonding layer)

The thermal conductivity of the bonding layer 14 of the wavelength conversion bonding member 10 of Examples and Comparative Examples was measured with an Xe flash analyzer (manufactured by NETZSCH, LFA 447) by the following method.

The results are shown in Table 1.

### (Production of wavelength conversion heat dissipation member)

A thermal conductive grease (trade name "MX-4", thermal conductivity 8.5 W/m·K, manufactured by Arctic) was applied on the surface of the bonding layer 14 of the wavelength conversion bonding member 10 of Examples and Comparative Examples, and then through the thermal conductive grease layer, a heat sink as the sufficiently sized heat diffusion retention member 9 was bonded to the bonding layer 14. In this manner, the wavelength conversion heat dissipation member 6 of Examples and Comparative Examples was manufactured (ref: FIG. 3E).

### Evaluation

### 1. Surface temperature of phosphor when LD device was turned on

### (1) With light output of 1.6 W

An LD device (trade name "NDB 7875", maximum 1.6 W light output, manufactured by NICHIA CORPORATION) connected to a power source (manufactured by NEOARK Corporation) and a radiator were prepared. An electric current of 1200 mA was applied to the LD device, and laser light was applied to the wavelength conversion heat dissipation member of Examples and Comparative Examples, thereby allowing the wavelength conversion heat dissipation member to emit light. The maximum temperature of the surface of the phosphor after the wavelength conversion heat dissipation member is allowed to emit light for 1 minute was measured with a thermograph.

The temperature of less than 55°C was evaluated as Excellent, 55°C or more and less than 100°C was evaluated as Good, and 100°C or more was evaluated as Bad.

The results are shown in Table 1.

### (2) With light output of 4.8 W

The plurality of the above-described LD devices were set and adjustment was conducted to give a light output of 4.8 W, and laser light was applied to the wavelength conversion heat dissipation member of Examples and Comparative Examples, thereby allowing the wavelength conversion heat dissipation member to emit light. The surface temperature of the phosphor after the wavelength conversion heat dissipation member was allowed to emit light after 1 minute was measured with a thermograph.

The temperature of less than 55°C was evaluated as Excellent, 55°C or more and less than 150°C was evaluated as Good, and 150°C or more was evaluated as Bad.

The results are shown in Table 1.

### 2. Light reflection efficiency from phosphor when LD device was turned on

The wavelength conversion heat dissipation member of Examples and Comparative Example made in the above-described 1. was disposed at a center position of the integrating sphere having a side face with micropores formed therein. Then, laser light with the above-described 1. (1) (light output of 1.6 W) conditions was applied to the wavelength conversion heat dissipation member from outside of the integrating sphere through the micropores, and reflected radiant flux after light emission for 1 minute was measured.

Meanwhile, instead of the wavelength conversion heat dissipation member, a reflection mirror of 99% or more with a laser wavelength in a wavelength region of 440 to 450 nm was disposed, and the reflected radiant flux was measured in the same manner.

The reflected radiant flux Y of the wavelength conversion dissipation member relative to the reflected radiant flux X of reflection mirror was calculated in percentage. That is, the calculation is conducted with the calculation formula "(Y/X) × 100".

85% or more was evaluated as Excellent, 75% or more and less than 85% was evaluated as Good, and less than 75% was evaluated as Bad.

The results are shown in Table 1.

### 3. Reliability over time

The wavelength conversion bonding member of Examples and Comparative Examples was set in a dry furnace of 200°C for 1000 hours, and thereafter, the bonding layer reflectivity was measured. The changes in reflectivity after setting in the dry furnace relative to the initial reflectivity were measured.

90% or more was evaluated as Good, 50% or more and less than 90% was evaluated as Average, and less than 50% was evaluated as Bad.

**[Table 1]**

| | | Example 1 | Example 2 | Example 3 | Example 4 | Example 5 | Example 6 | Example 7 | Example 8 | Comparative Example 1 | Comparative Example 2 | Comparative Example 3 | Comparative Example 4 |
|---|---|---|---|---|---|---|---|---|---|---|---|---|---|
| Bonding layer | Composition | Preparation Example 1 | Preparation Example 1 | Preparation Example 2 | Preparation Example 3 | Preparation Example 4 | Preparation Example 5 | Preparation Example 6 | Preparation Example 1 | Preparation Example 1 | Preparation Example 3 | Preparation Example 7 | Preparation Example 8 |
| | | Ceramic ink | Ceramic ink | Silicone resin/Silver particles | Silicone resin/BTO particles | sodium silicate/BTO particles | Silicone resin/titanium dioxide | Silicone resin/aluminum oxide | Ceramic ink | Ceramic ink | Silicone resin/BTO particles | Silver paste | Acrylic resin/BTO particles |
| | Shape | FIG. 2A,B | FIG. 2A,B | FIG. 2A,B | FIG. 2A,B | FIG. 2A,B | FIG. 2A,B | FIG. 2A,B | FIG. 4A,B | FIG. 2A,B | FIG. 2A,B | FIG. 2A,B | FIG. 2A,B |
| | Thickness (µm) | 100 | 120 | 100 | 100 | 100 | 100 | 100 | 100 | 75 | 75 | 100 | 100 |
| | Thermal conductivity (W/m·k) | 1.5 | 1.5 | 7.0 | 0.25 | 1.1 | 1.0 | 1.1 | 1.5 | 1.5 | 0.25 | 25 | 0.20 |
| | Reflectivity (%) | 91 | 96 | 90 | 95 | 94 | 96 | 95 | 91 | 85 | 84 | 76 | 95 |
| Evaluation | Phosphor temperature (1.6W) | Excellent | Good | Excellent | Good | Good | Good | Good | Excellent | Excellent | Good | Excellent | Bad |
| | Phosphor temperature(4.8W) | Excellent | Good | Good | Average | Good | Good | Good | Excellent | Excellent | Average | Excellent | Bad |
| | Light reflection efficiency | Good | Good | Good | Good | Good | Good | Good | Excellent | Bad | Bad | Bad | Good |
| | High temperature reliability | Good | Good | Average | Good | Average | Good | Good | Good | Good | Good | Bad | Bad |

While the illustrative embodiments of the present invention are provided in the above description, such is for illustrative purpose only and it is not to be construed as limiting in any manner. Modification and variation of the present invention which will be obvious to those skilled in the art are to be covered in the following claims.

### Industrial Applicability

The wavelength conversion bonding member, wavelength conversion heat dissipation member, and light-emitting device of the present invention can be applied to various industrial products, and for example, can be suitably used for lighting for vehicles, pendant light, road light, and stage lighting product including a semiconductor light-emitting device.

### [Description of reference numeral]

1 semiconductor light-emitting device
4 light source
5 reflection mirror
6 wavelength conversion bonding member
7 through hole
9 heat diffusion retention member
10 wavelength conversion heat dissipation member
13 phosphor ceramic element
14 bonding layer

## Claims

1. A wavelength conversion bonding member including a phosphor ceramic element and a bonding layer provided on one side of the phosphor ceramic element,
wherein the bonding layer has a thermal conductivity of more than 0.20 W/m·K, and
the bonding layer has a reflectivity of 90% or more.

2. The wavelength conversion bonding member according to Claim 1, wherein the bonding layer is formed from a ceramic ink.

3. The wavelength conversion bonding member according to Claim 1, wherein the bonding layer is formed from a curable resin composition containing a curable resin, and at least one inorganic particle selected from inorganic oxide particles and metal particles.

4. The wavelength conversion bonding member according to Claim 1, wherein the bonding layer has a thickness of 80 µm or more and 1000 µm or less.

5. A wavelength conversion heat dissipation member including the wavelength conversion bonding member according to Claim 1, and a heat diffusion retention member,
wherein the heat diffusion retention member is bonded to the phosphor ceramic element through the bonding layer.

6. A light-emitting device including a light source that applies light to one side,
a reflection mirror that is disposed on one side to face the light source in spaced-apart relation and in which a through hole for allowing the light to pass through is formed, and
the wavelength conversion heat dissipation member according to Claim 5 disposed on one side to face the reflection mirror in spaced-apart relation so that the light is applied to the phosphor ceramic element.
